# EUROPEAN PATENT APPLICATION

(11) **EP 1 981 067 A1**
(43) Date of publication of application: **15.10.2008**
(21) Application number: 07707620.6
(22) Date of filing: 29.01.2007
(51) Int. Cl.: H01L 21/203, C23C 14/24

(54) **MOLECULAR BEAM CELL HAVING PURGE FUNCTION**

(30) Priority: 30.01.2006 JP 2006020724
(71) Applicant: ROHM CO., LTD., Kyoto-shi, Kyoto 615-8585 (JP)
(72) Inventor: YAMAMOTO, Takatoshi, Kyoto-shi, Kyoto 601-8142 (JP); UMEMOTO, Shinya, Kyoto-shi, Kyoto 601-8142 (JP); TANABE, Tetsuhiro, Kyoto-shi, Kyoto 615-8585 (JP); NISHIMOTO, Yoshio, Kyoto-shi, Kyoto 615-8585 (JP)
(74) Representative: McLeish, Nicholas Alistair Maxwell
(86) International application number: PCT/JP2007/051389
(87) International publication number: WO 2007/086560

(57) **Abstract**

A molecular beam cell includes a crucible (2) for containing a material (29), a coil heater (3) for heating the material (29), and a side reflector (5) for reflecting the heat from the coil heater (3). The molecular beam cell further includes a base (7) supporting the crucible (2), the coil heater (3) and the side reflector (5). The base (7) is held by a disc-shaped flange (9) via a plurality of posts (20). A purge gas introduction pipe (44) for supplying purge gas (48) into the crucible (2) is provided, whereby ambient gas (36) is prevented from coming into contact with the material (29).

## Description

### TECHNICAL FIELD

The present invention relates to a molecular beam cell used for a molecular beam epitaxy apparatus. More specifically, the present invention relates to a molecular beam cell designed to introduce purge gas to prevent an unnecessary product other than a target product from being formed.

### BACKGROUND ART

Molecular beam epitaxy (MBE) is known as one of the methods for forming a thin film on the surface of a substrate. In this method, a molecular beam cell containing a material is heated in a chamber maintained under ultra high vacuum. As a result, molecules (or atoms) forming the material travel straight like a narrow line in the vacuum. (This flow of molecules is called "molecular beam".) The molecular beam impinges on the surface of a heated substrate and reacts with the surface to form a reaction product. By the deposition of the reaction product, a desired thin film is formed on the substrate surface.

There are various types of molecular beam cells. In a molecular beam cell designed to use a solidmaterial, the material is put in a crucible, and the crucible is heated by a heater. Such a crucible may be made of pyrolytic boron nitride (PBN). To use a gas material, a gas-source cell connected to an external gas cylinder is used. When a molecular beam of stable gas such as nitrogen or oxygen is necessary, a radical cell is used. The radical cell incorporates an electric discharge mechanism for exciting the introduced gas to form radicals. Examples of molecular beam cells are disclosed in Patent Documents 1-9 given below:
Patent Document 1: JP-U-H04-013056
Patent Document 2: JP-U-H04-013057
Patent Document 3: JP-U-H04-013058
Patent Document 4: JP-U-H03-022067
Patent Document 5: JP-U-H03-038367
Patent Document 6: JP-U-H04-018427
Patent Document 7: JP-U-H04-025870
Patent Document 8: JP-U-H04-133427
Patent Document 9: JP-U-S63-199172

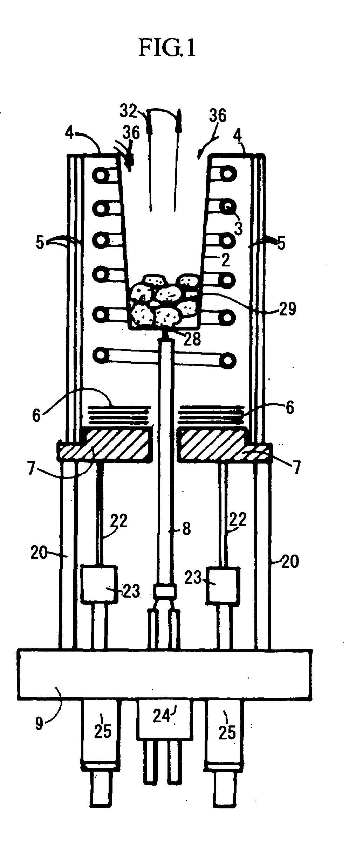

Referring to Fig. 1, a conventional molecular beam cell will be described below. The molecular beam cell shown in the figure includes a crucible 2 in the form of a bottomed cylinder and a coil heater 3 surrounding the crucible. The coil heater 3 is used for heating the material contained in the crucible 2. A cylindrical side reflector 5 for reflecting the heat from the heater 3 toward the crucible 2 is provided around the crucible 2. The crucible 2 includes a collar portion 4 supported by the upper end of the side reflector 5. The side reflector 5 is in the form of a cylinder made by laminating a plurality of thin tantalum plates. A bottom reflector 6 made by laminating a plurality of thin tantalumplates is arrangedbelow the crucible 2.

The reflector 5, the reflector 6 and the crucible 2 are supported by a disc-shaped base 7. The base 7 includes a stepped periphery to which the side reflector 5 is fitted. The bottom reflector 6 is arranged at the center of the base 7. An end 28 of a thermocouple 8 for detecting the temperature of the crucible 2 is held in contact with the bottom of the crucible 2. The base 7 is mounted to a cylindrical flange 9 via posts 20. The flange 9 is used for mounting the molecular beam cell to a cell port of a molecular beam epitaxy apparatus.

A thermocouple feedthrough 24 is mounted to the flange 9. Heater current terminals 22, 22 are arranged above the flange 9 to be connected to the two ends of the coil heater 3. The flange 9 is provided with current feedthroughs 25, 25. Junctions 23, 23 connect the wires extending from the current feedthroughs to the heater current terminals 22, 22.

A molecular beam epitaxy apparatus includes a wall formed with a plurality of ports for mounting molecular beam cells having the above-described structure. A shutter which is rotatable around a predetermined axis is provided on each molecular beam cell. After the material is put into the molecular beam cell, the cell is mounted to a port of the molecular beam epitaxy apparatus. A substrate is mounted to a manipulator arranged at an upper portion in the chamber. The manipulator incorporates a heater.

After the interior of the chamber is held under ultra high vacuum, the substrate is heated to an appropriate temperature. Further, the material is heated to an appropriate temperature by energizing the heater of the molecular beam cell. When the melting point of the solid material is low, the material once liquefies and then evaporates to form a molecular beam. When the melting point of the solid material is high, the material sublimates to form a molecular beam. By controlling the opening and closing of the shutter, the molecular beam is appropriately caused to impinge on the substrate. As a result, a thin film of a desired composition is formed.

Zinc oxide (ZnO) is one of the materials which can easily produce polycrystalline powder. Since high-purity zinc oxide is excellent in ultraviolet absorption and insulation, it is often used for e.g. a resin stabilizer, an electrophotograph photosensitive material or a fluorescent material. ZnO has a wide band gap (Eg=3,37eV, λg=368nm) corresponding to ultraviolet/blue energy. If a good light emitting element can be produced using ZnO, it can be widely used instead of a GaN-based blue light emitting element. (ZnO is more inexpensive than GaN.) Further, considering the band gap, it may be possible to manufacture an ultraviolet light emitting element using ZnO.

However, the formation of p-type ZnO is difficult, which is a drawback common to the semiconductors having a wide band gap. Although the formation of p-type ZnO by various methods or by using various kinds of dopant has been reported, stable growth over a wide area has not been achieved.

Conventionally, an attempt has been made to grow ZnO on a sapphire substrate. Since ZnO does not become a liquid phase, it is grown from the gas phase by vapor deposition, sputtering, CVD or MBE, for example. To form ZnO single crystal on a substrate by molecular beam epitaxy, oxygen (O) and zinc (Zn) are used as the material. To enhance the reactivity, oxygen molecules are decomposed into atoms and supplied to the substrate as radicals. Zinc is a silvery white shinymetal having a melting point of 419.58 °C, a boiling point of 907 °C and a density of 7.13 g/cm³. Zinc becomes brittle above 200 °C and can be pulverized. Since zinc melts when heated, the formation of a molecular beam using such a molecular beam cell as shown in Fig. 1 has been already achieved. Alternatively, zinc can be sublimated at relatively low temperature to form a molecular beam.

For instance, to form a thin film of a semiconductor such as GaAs, GaAlAs, GaP or InP of groups III-V by molecular beam epitaxy, Zn may be used as a p-type dopant. In this case, only a small amount of Zn is necessary, and continuous use for a long period is possible even when the molecular beam cell is small. It is also possible to form a thin film of ZnSe by molecular beam epitaxy. In this case, Zn is used not as a dopant but as a main material (so that a relatively large amount is consumed). Selenium (Se), which is the other main material, is solid at ordinary temperature and has a low vapor pressure. Thus, a molecular beam of Zn is properly formed using the conventional molecular beam cell shown in Fig. 1.

However, to form a thin film of ZnO by molecular beam epitaxy has the following drawbacks. In this method, the molecular beam of Zn and radicals of oxygen react with each other on the substrate to form a thin film of ZnO. In this process, however, only a small part of the material constituting the molecular beam becomes the thin film, and most part of the material separates from the substrate without being used for the thin film formation. Since a vacuum pumping system is constantly working, exhaust gas containing the unreacted substance is discharged from the chamber. When all the main materials are those which are solid at ordinary temperature, the vapor pressure of the materials is relatively low, so that there are no problems.

However, the materials which are gas at ordinary temperature generally have a high vapor pressure and remain within the chamber to some degree to form ambient gas even when the vacuum pumping system is working. This residual material enters the molecular beam cell of other solid or liquid material and chemically reacts with the solid or liquid material to form a reaction product. Some reaction products may have a sublimation point or a melting point which is higher than that of the material in the molecular beam cell. In such a case, the reaction products do not exit the crucible as a molecular beam but remain in the crucible. This means that some of the material is wasted, which is not desirable.

In the case where a thin film of ZnO is to be formed, oxygen is used as one of the main materials. Thus, oxygen remains in the chamber as ambient gas with a high partial pressure. When oxygen enters the crucible of the molecular beam cell for Zn, it immediately reacts with Zn at high temperature to produce ZnO. Since the sublimation point of ZnO is higher than that of Zn, ZnO does not form a molecular beam but remains in the crucible as an unnecessary product. The unnecessary product (ZnO) is so formed as to cover the surfaces of the Zn material. Thus, the take-out rate or consumption rate of the material (which depends on the vapor pressure of Zn) varies with time, which is not desirable. Examples of possible ambient gas other than oxygen include nitrogen (which forms InN or GaN as an unnecessary product in forming an InGaN thin film) and sulfur (which forms ZnS as an unnecessary product in forming a ZnS thin film). When a thin film of a chemical compound of group VII such as chloride, bromide or fluoride is formed, chlorine gas, bromine gas or fluorine gas is produced as ambient gas.

The reaction of ambient gas with the material further causes the following problems. In driving a molecular beam epitaxy apparatus, the interior of the chamber is held under ultra high vacuum of 10⁻⁸ to 10⁻⁹ Pa before the formation of a molecular beam is started. (The pressure becomes about 10⁻³ to 10⁻⁵ Pa when a molecular beam is being formed.) It takes a relatively long time to provide such ultra high vacuum in the chamber. Thus, when the interior of the chamber is once returned to atmospheric pressure, it takes a long time before the apparatus becomes ready for the operation. Thus, it is preferable to make the number of times of breaking vacuum as small as possible. For this purpose, e.g. a preliminary vacuum room or a sample preparation room is provided in front of the chamber and connected to the chamber via a gate valve so that the transfer or replacement of a wafer can be performed while maintaining the vacuum.

However, it is inevitable that the interior of the chamber is returned to atmospheric pressure in supplying a solidmaterial into the molecular beam cell. As noted above, since the material reacts with ambient gas to form a reaction product, the material is reduced as much. As a result, the supply of the material, which requires breaking vacuum, needs to be performed more often than expected, which considerably deteriorates the operation efficiency.

### DISCLOSURE OF THE INVENTION

The present invention is proposed under the circumstances described above. It is, therefore, an object of the present invention to provide a molecular beam cell in which ambient gas and the material do not come into contact with each other.

A molecular beam cell provided according to the present invention includes a crucible, a heater, a reflector, a base, a flange and a purge gas introduction pipe. The crucible includes a bottom and contains a material. The heater heats the material. The reflector reflects the heat from the heater. The base supports the crucible, the heater and the reflector. The flange holds the base. The purge gas introduction pipe supplies purge gas into the crucible.

Preferably, the molecular beam cell of the present invention further comprises a material-holding support plate arranged in the crucible for holding the material. The material-holding support plate is formed with a plurality of through-holes. The purge gas introduction pipe is connected to an opening formed at the bottom of the crucible.

Preferably, the molecular beam cell further comprises a shielding member covering the opening and formed with a hole for allowing the purge gas to pass therethrough.

Preferably, the purge gas introduction pipe includes a purge gas jetting nozzle which is positioned higher than the bottom of the crucible. The purge gas jetting nozzle is not in contact with the crucible.

The purge gas introduction pipe may include a tubular ring positioned above the crucible. The tubular ring is formed with a plurality of holes for jetting out the purge gas.

The molecular beam cell according the present invention may further comprise an additional support plate positioned between the material-holding support plate and the bottom of the crucible.

Preferably, the additional support plate is formed with a plurality of through-holes. The positions of the through-holes of the additional support plate are deviated from the positions of the through-holes of the material-holding support plate in the horizontal direction.

Preferably, the through-holes of the material-holding support plate are arranged on a circle having a first radius, whereas the through-holes of the additional support plate are arranged on a circle having a second radius. In this case, the first radius and the second radius are made different from each other.

Other features and advantages of the present invention will become more apparent from the detailed description given below with reference to the accompanying drawings.

### BRIEF DESCRIPTION OF THE DRAWINGS

Fig. 1 shows a conventional molecular beam cell.
Fig. 2 shows a molecular beam cell according to a first embodiment of the present invention.
Fig. 3 shows a crucible of the molecular beam cell shown in Fig. 2.
Fig. 4 shows a crucible of a molecular beam cell according to a second embodiment of the present invention.
Fig. 5 shows a crucible of a molecular beam cell according to a third embodiment of the present invention.
Fig. 6 is a variation of the structure shown in Fig. 5.
Fig. 7 is a variation of the structure shown in Fig. 4.
Fig. 8 is a plan view of the upper support plate shown in Fig. 7.
Fig. 9 is a plan view of the lower support plate shown in Fig. 7.

### BEST MODE FOR CARRYING OUT THE INVENTION

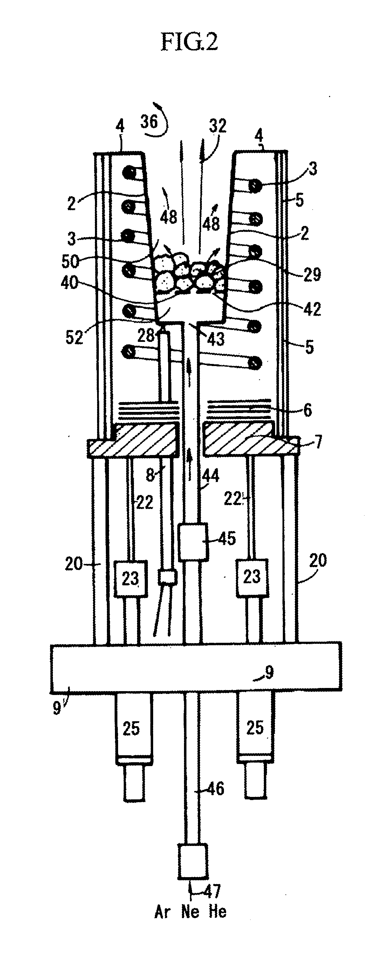

Fig. 2 shows a molecular beam cell according to a first embodiment of the present invention. The molecular beam cell of this embodiment includes a crucible 2 which is a container in the form of a bottomed cylinder. The crucible 2 may be made of pyrolytic boron nitride (PBN). Alternatively, the crucible 2 may be made of quartz (SiO₂), tantalum (Ta), molybdenum (Mo) or tungsten (W). Specifically, Ta, Mo and W, which are metals having a high melting point, can be used when they are not to react with the material for forming a thin film (hereinafter referred to as "thin-film material"). Quarts can be used when the molecular beam cell is not to be heated to high temperature. Since the working of quartz is easy, quartz is suitable for making a crucible having a complicated shape.

A coil heater 3 for heating the thin-film material is arranged around the crucible 2. Instead of the coil heater, a ribbon heater may be used. The coil heater 3 may be made of tungsten (W) or tantalum (Ta). A cylindrical side reflector 5 for reflecting the heat from the heater 3 toward the crucible 2 is arranged around the crucible 2. The side reflector 5 is formed by coaxially arranging a plurality of metal cylinders made of thin plates of tantalum. Each of the metal cylinders is provided with a plurality of projections formed by a punch or a chisel, so that the metal cylinders are spaced from each other. Due to the presence of the spaces, the heat from the coil heater 3 is properly reflected toward the crucible 2. The upper end of the side reflector 5 is connected to the reverse surface of a color portion 4 of the crucible 2. Thus, the crucible 2 is supported by the side reflector 5.

A bottom reflector 6 is arranged below the crucible 2. The bottom reflector 6 is formed by laminating a plurality of thin disc-shaped plates of tantalum. Similarly to the side reflector 5, each of the thin disc-shaped plates is formed with a plurality of projections. Thus, the thin plates are spaced from each other, so that the heat is properly reflected toward the crucible 2. An end 28 of a thermocouple 8 for detecting the temperature of the crucible 2 is held in contact with the bottom of the crucible 2.

The side reflector 5, the bottom reflector 6 and the crucible 2 are supported by a disc-shaped base 7. The base 7 may be made of molybdenum (Mo). The periphery of the base 7 is formed with a stepped portion to which the lower end of the side reflector 5 is fitted. The bottom reflector 6 is arranged at the center of the base 7. The base 7 is fixed to a cylindrical flange 9 via a plurality of posts 20. The flange 9 is used for mounting the molecular beam cell to a cell port of a molecular beam epitaxy apparatus. The flange 9 and the posts 20 may be made of stainless steel. The flange 9 is mounted to a port flange of the molecular beam epitaxy apparatus by certain fixation means (e.g. a bolt and a nut).

The flange 9 is provided with a thermocouple feedthrough (not shown in Fig. 2, see reference sign 24 in Fig. 1) and two current feedthroughs 25. Two heater current terminals 22 extending vertically in Fig. 2 are arranged above the flange 9. Each of the heater current terminals 22 is connected to a respective end of the coil heater 3. The wires arranged in the current feedthroughs 25 are connected to the heater current terminals 22 via junctions 23. The thermocouple feedthrough and the current feedthroughs are used for performing temperature detection and current supply while maintaining the vacuum in the chamber of the molecular beam epitaxy apparatus.

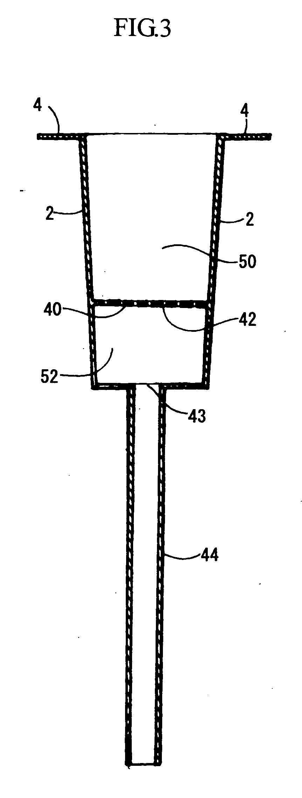

Fig. 3 is an enlarged view of the crucible 2 according to the present invention. The bottom of the crucible 2 is formed with an opening 43 from which a gas introduction pipe 44 extends downward. The gas introduction pipe 44 is made of PBN and formed integral with the crucible 2.

A support plate 40 is arranged in the crucible 2. As shown in Fig. 3, the support plate 40 is fixed to the inner wall of the crucible 2 and formed with a plurality of through-holes 42. The support plate 40 divides the crucible 2 into an upper compartment 50 and a lower compartment 52. The thin-film material 29 (see Fig. 2) is placed on the support plate 40, i.e., in the upper compartment 50. The lower compartment 52 is left empty. The lower compartment 52 serves to spread purge gas uniformly.

As shown in Fig. 2, a joint 45 is mounted to the lower end of the gas introduction pipe 44. The upper end of a purge gas pipe 46 is connected to the joint. The purge gas pipe 46 is made of metal such as stainless steel and penetrates the flange 9. A gas introduction port 47 is provided at the lower end of the purge gas pipe 46. Though not illustrated, the gas introduction port 47 is connected to a gas cylinder via e.g. a gas pipe. An inert gas (e.g. Ar, Ne or He) as the purge gas is supplied from the gas introduction port 47.

The purge gas flows through the purge gas pipe 46 and then through the gas introduction pipe 44 to jet out into the crucible 2 through the opening 43. Then, the purge gas flows through the gaps between the lumps of the thin-film material 29 to become diffusion purge gas 48 and exits the crucible 2 from the upper opening. The thin-film material 29 is heated by the heater 3 and sublimates to form a molecular beam 32. The molecular beam 32 travels straight to reach a substrate (not shown) to form a thin film on the substrate. In the case where other thin-film material is a gas, the gas remains in the chamber with a relatively high partial pressure to form ambient gas (see reference sign 36 in Fig. 1).

In this embodiment, since the purge gas flows upward from the bottom of the crucible 2, the ambient gas 36 cannot enter the crucible 2. Thus, the thin-film material 29 does not chemically react with the ambient gas 36, so that the change of properties (e.g. oxidation or nitriding) of the thin-film material 29 is prevented. This ensures that the thin-film material 29 is used completely. Further, the take-out rate of the thin-film material is prevented from varying. Moreover, since the vacuum chamber does not need to be opened frequently, the efficiency of the molecular beam epitaxy apparatus is enhanced. In this embodiment, the lower compartment 52 exists under the thin-film material 29. The purge gas introduced into the crucible 2 appropriately spreads in the lower compartment 52 and then flows through the through-holes 42 and between the lumps of the thin-film material 29. Thus, the ambient gas 36 (e.g. oxygen or nitrogen) entering the crucible 2 is completely purged.

The support plate 4 0 may be removably mounted to the crucible 2 or permanently fixed to the crucible 2. Each through-hole 42 of the support plate 40 can have any dimension as long as it does not allow the thin-film material to drop to the lower compartment 52. For instance, through-holes 42 each having a diameter of 1 mm may be arranged at intervals of 1 mm. The support plate 40 may be entirely flat as shown in the figure or may be curved to project downwardly. Instead of the flat plate member, use may be made of a hemispherical member or semioval member formed with through-holes.

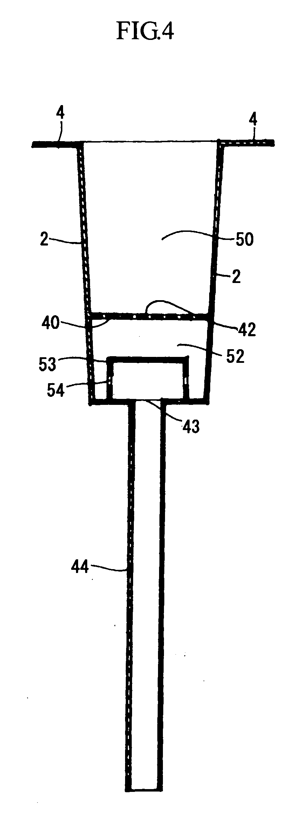

Fig. 4 shows a crucible 2 of a molecular beam cell according to a second embodiment of the present invention. Unlike the structure shown in Fig. 3, the crucible of this embodiment is provided with a shielding member 53 covering the opening 43 at the bottom of the crucible. The side wall of the shielding member 53 is formed with a plurality of holes 54 for allowing the purge gas to pass therethrough. However, the upper wall of the shielding member is not formed with any holes. With this arrangement, even when small lumps of thin-film material drop through the through-holes 42 of the support plate 40, the shielding member 53 prevents the thin-film material from dropping into the gas introduction pipe 44 through the opening 43. Further, with this arrangement, the purge gas introduced into the crucible 2 does not come into direct contact with the thin-film material. Thus, the temperature of the heated thin-film material is maintained.

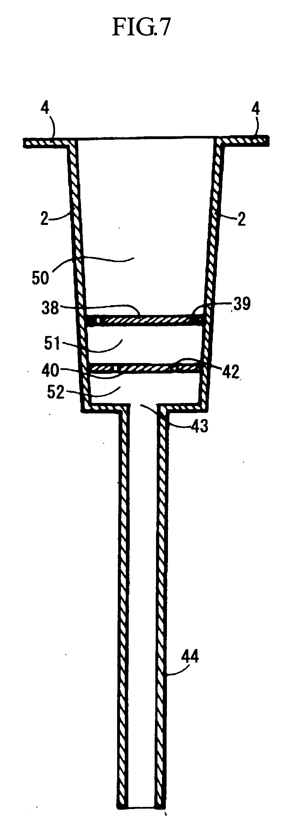

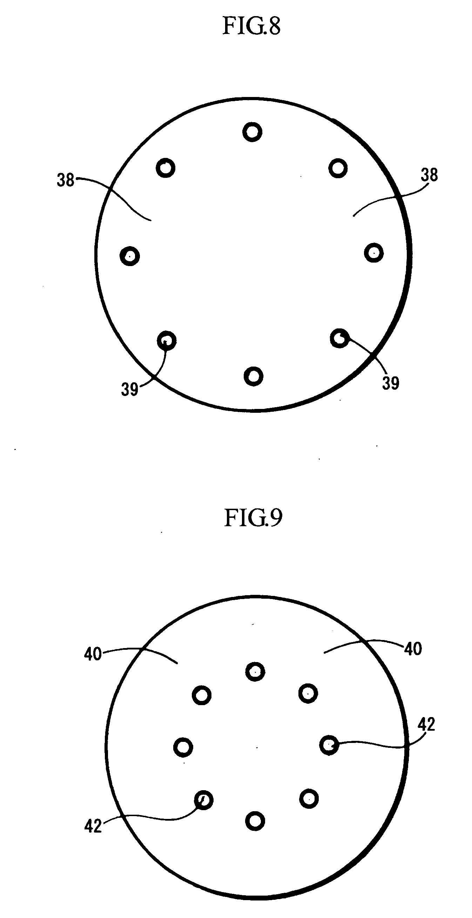

Alternatively, the shielding means for the thin-film material may be structured as shown in Fig. 7. The crucible 2 shown in the figure is provided with an upper and a lower support plates 38 and 40, whereby the interior of the crucible 2 is divided into an upper compartment 50, a middle compartment 51 and a lower compartment 52. The thin-film material is placed on the upper support plate 38. As shown in Figs. 8 and 9, the support plates 38 and 40 are formed with a plurality of through-holes 39 and 42, respectively. The through-holes 39 are arranged at equal intervals along the periphery of the upper support plate 38 (i.e., on a circle having a predetermined radius) (see Fig. 8). The through-holes 42 are arranged at equal intervals on a circle having a radius which is substantially half the radius of the lower support plate 40 (see Fig. 9). The radius of the circle on which the through-holes 39 are arranged and that of the circle on which the through-holes 42 are arranged differ from each other. Thus, when the support plates 38 and 40 are mounted to the crucible 2 (see Fig. 7), the positions of the through-holes 39 and the positions of the through-holes 42 are deviated from each other in the horizontal direction. Specifically, the through-holes 39 are positioned farther from the central axis (not shown) of the crucible 2 than the through-holes 42 are. With this arrangement, even when small lumps of thin-film material drop through the through-holes 39 of the upper support plate 38, the lower support plate 40 prevents the thin-film material from dropping into the gas introduction pipe 44. The arrangement of the through-holes 39 and/or 42 may be determined in view of the inclination angle at which the molecular beam cell is mounted to the molecular beam epitaxy apparatus. For instance, when the molecular beam cell is mounted with a predetermined inclination angle to the vertical, the through-holes 42 may be so arranged that any of the through-holes 42 is not positioned on a line extending vertically through the opening 43.

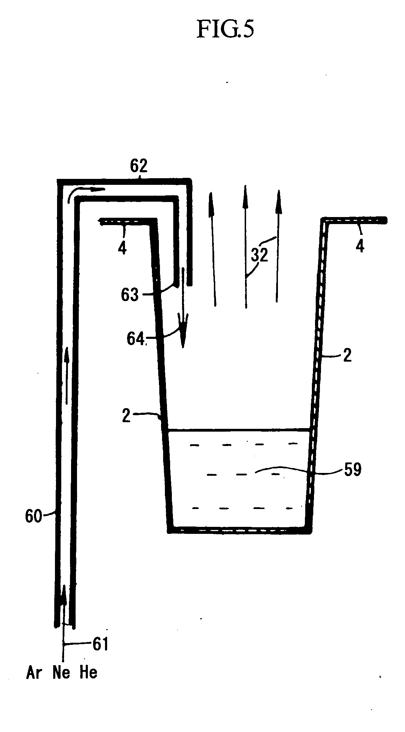

In the foregoing embodiments, use is made of a thin-film material which sublimates when heated. Unlike this, a thin-film material (e.g. Mg, In, Ga, Al, Cu, Ag or Au) which once liquefies when heated may be used. In this case, an opening is not formed at the bottom of the crucible 2, and purge gas is introduced from the top of the crucible. Fig. 5 shows a crucible of a molecular beam cell according to a third embodiment of the present invention. The illustrated crucible 2 contains thin-film material 59 liquefied by heating. The thin-film material 59, when further heated, evaporates to form a molecular beam 32.

A purge gas introduction pipe for supplying purge gas extends into the crucible 2. As shown in Fig. 5, the purge gas introduction pipe includes a vertical portion 60, a horizontal portion 62 and a terminating end 63. The vertical portion 60 extends vertically outside the crucible 2. The horizontal portion 62 is positioned above the collar portion 4 of the crucible 2. The terminating end 63 extends downward from the horizontal portion 62 to partially enter the crucible 2. The purge gas is jetted out into the crucible 2 through the opening (purge gas jetting nozzle) of the terminating end 63 to be sprayed to the thin-film material 59. The purge gas jetting nozzle is positioned higher than the liquid level of the thin-film material 59 (i.e., higher than the bottom of the crucible 2) and is not in contact with the crucible 2. With this arrangement, the ambient gas is prevented from coming into contact with the thin-film material 59. The structure shown in Fig. 5 can be employed also when a thin-film material which does not liquefy (i.e., which sublimates) is used.

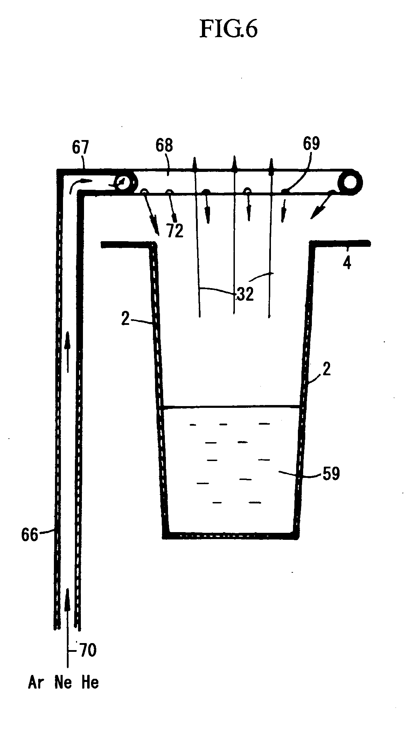

Fig. 6 shows a variation of the structure of Fig. 5. With the structure shown in Fig. 6, the purge gas is uniformly sprayed to the liquid surface of the thin-filmmaterial. Specifically, the purge gas introduction pipe shown in the figure includes a vertical portion 66 which extends vertically and a horizontal portion 67. Part of the horizontal portion 67 forms a tubular ring 68. In the illustrated example, the inner diameter of the tubular ring 68 is larger than the maximum inner diameter of the crucible 2. With this arrangement, the tubular ring does not block the molecular beam 32. The bottom of the tubular ring 68 is formed with a plurality of holes 69 for jetting out the purge gas 37. The holes 69 are formed at an inner portion of the tubular ring 68 so that the jetted purge gas efficiently comes into contact with the thin-film material.

In the example shown in Fig. 6 again, when the thin-film material 59 in the liquid state contained in the crucible 2 is heated, the thin-film material evaporates to form a molecular beam 32. The purge gas 70 is supplied through the vertical portion 66 and horizontal portion 67 of the purge gas introduction pipe to jet out into the crucible 2 through the holes 69 of the tubular ring 68. Thus, the ambient gas is prevented from entering the crucible 2.

## Claims

1. A molecular beam cell comprising:
a crucible for containing a material, the crucible including a bottom;
a heater for heating the material;
a reflector for reflecting heat from the heater;
a base supporting the crucible, the heater and the reflector;
a flange holding the base; and
a purge gas introduction pipe for supplying purge gas into the crucible.

2. The molecular beam cell according to claim 1, further comprising a material-holding support plate arranged in the crucible for holding the material, wherein the material-holding support plate is formed with a plurality of through-holes, and wherein the purge gas introduction pipe is connected to an opening formed at the bottom of the crucible.

3. The molecular beam cell according to claim 2, further comprising a shielding member covering the opening and formed with a hole for allowing the purge gas to pass therethrough.

4. The molecular beam cell according to claim 1, wherein the purge gas introduction pipe includes a purge gas jetting nozzle which is positioned higher than the bottom of the crucible and which is out of contact with the crucible.

5. The molecular beam cell according to claim 1, wherein the purge gas introduction pipe includes a tubular ring positioned above the crucible, the tubular ring being formed with a plurality of holes for jetting out the purge gas.

6. The molecular beam cell according to claim 2, further comprising an additional support plate positioned between the material-holding support plate and the bottom of the crucible.

7. The molecular beam cell according to claim 6, wherein the additional support plate is formed with a plurality of through-holes, and wherein positions of the through-holes of the additional support plate are deviated from positions of the through-holes of the material-holding support plate in a horizontal direction.

8. The molecular beam cell according to claim 7, wherein the through-holes of the material-holding support plate are arranged on a circle having a first radius, whereas the through-holes of the additional support plate are arranged on a circle having a second radius, the first radius and the second radius being different from each other.
